Europäisches Patentamt

European Patent Office

Office européen des brevets

(11) Publication number: **0 323 059**
**A2**

## (12) EUROPEAN PATENT APPLICATION

(21) Application number: **88311631.1**

(51) Int. Cl.⁴: **H03F 3/72**

(22) Date of filing: **08.12.88**

(30) Priority: **21.12.87 JP 324725/87**

(43) Date of publication of application:
**05.07.89 Bulletin 89/27**

(84) Designated Contracting States:
**DE FR GB IT**

(71) Applicant: **SEIKO INSTRUMENTS INC.**
**31-1, Kameido 6-chome Koto-ku**
**Tokyo 136(JP)**

(72) Inventor: **Hishiki, Yuji**
**c/o Seiko Instruments Inc. 31-1 Kameido**
**6-chome**
**Koto-ku Tokyo(JP)**

(74) Representative: **Caro, William Egerton et al**
**J. MILLER & CO. Lincoln House 296-302 High**
**Holborn**
**London WC1V 7JH(GB)**

(54) **Amplifier circuit.**

(57) An amplifier circuit comprises a differential amplifier (D) having active loads (1,2), and a driver circuit (0) provided on the output side of the differential amplifier. Switching means (5) are provided for controlling the supply of operating current to the differential amplifier, and clamping means (22) are provided for clamping the input to the driver circuit to a predetermined level in association with the switching operation of the switching means.

*F I G.1*

## AMPLIFIER CIRCUIT

The present invention relates to an amplifier circuit.

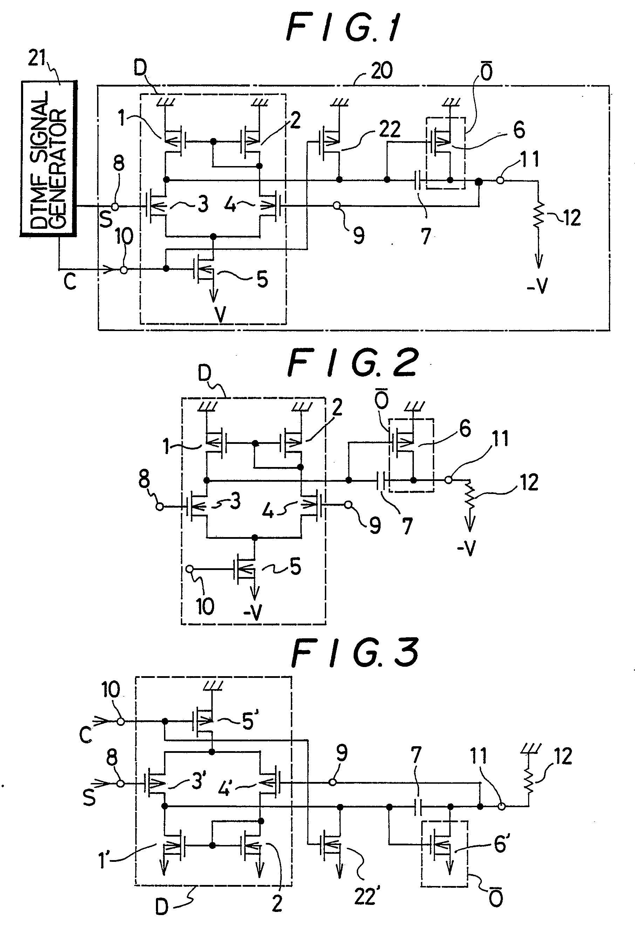

An amplifier circuit as shown in Figure 2 has previously been used in a telephone system for providing a buffer between a DTMF signal generator and a telephone line. The amplifier circuit comprises: a differential amplifier D including a pair of N channel type transistors 3 and 4 and a pair of P channel type transistors 1 and 2 which are connected in a current mirror form and which provide an active load on the side of a drain circuit of the transistors 3 and 4; and P channel type transistor 6 which is connected to the drain of the transistor 3 and constitutes an open drain type driver circuit. The DTMF signal is applied between differential input terminals 8 and 9 of the differential amplifier D, which terminals are connected to the gates of the transistors 3 and 4, and is collected by an outside resistor 12 connected between an output terminal 11 of the driver circuit and a power supply -V. A capacitor 7 is provided for preventing oscillation.

Now, the output of the DTMF signal is required for a limited short period of time, i.e. during a dialling operation in the telephone system. For this purpose, the differential amplifier D is supplied with a driving electric current only for such a desired period under the control of an N channel type transistor 5 functioning as a switching element, which is provided between the power supply -V and the sources of the transistors 3 and 4. The state of the transistor 5 is controlled in accordance with the level of a control voltage signal C supplied to a control input terminal 10.

The control voltage signal C is output by the DTMF signal generator in association with the generation of the DTMF signal, and assumes earth level (an "H" state) only when the transmission of the DTMF signal to the outside is required. The transistor 5 is then rendered conductive, and the differential amplifier D is brought into its operational state. On the other hand, if there is no need for the output of the DTMF signal, the control voltage signal C assumes the level of the power supply voltage -V (an "L" state). The transistor 5 is turned OFF, thus hindering a flow of electric current into the differential amplifier D. As a result, the consumption of electric power is reduced.

In the conventional circuit described above, as shown in Figure 2, when the transistor 5 is turned OFF, the electric potential at the drain of the transistor 3 increases, thereby holding the transistor 6 of the driver circuit 0 in the OFF state. In the case of an active load, however, the voltage at the drain of the transistor 3 is not increased to earth potential because of the threshold voltage cf the transistor 2. Instead, a floating state is created, and it follows that the electric potential at the output of the open drain type driver circuit fluctuates. This may cause a malfunction of a device or a circuit which is connected to the output of the amplifier circuit.

It is an object of the invention to provide an improved amplifier circuit which is free from such electric potential fluctuations.

According to the present invention, there is provided an amplifier circuit comprising a differential amplifying device for receiving input signals from a signal generator, a driver circuit responsive to an input received from the differential amplifying device for generating output signals, and switching means for receiving control signals from the signal generator and for controlling the supply of operating current to the differential amplifying device in response to the control signals, and characterised by clamping means arranged so as to clamp the input to the driver circuit to a predetermined level in association with the control by the switching means of the supply of operating current to the differential amplifying device.

The invention will be described further, by way of example, with reference to the accompanying drawings, in which:-

Figure 1 is a circuit diagram illustrating one embodiment of an amplifier circuit according to the present invention;

Figure 2 is a circuit diagram illustrating a conventional amplifier circuit; and

Figure 3 is a circuit diagram illustrating a modification of the circuit shown in Figure 1.

Turning to Figure 1, there is illustrated one embodiment of an amplifier circuit according to the present invention, which in this instance, is employed as a buffer amplifier in a telephone system wherein a DTMF signal generated by a DTMF signal generator is to be transmitted to a telephone line.

The amplifier circuit generally indicated at 20 includes: an active load type differential amplifier D having a pair of N channel type transistors 3 and 4; and a driver circuit 0 comprising a P channel type transistor 6 provided on the output side of the differential amplifier D. The differential amplifier D further includes a transistor 5 functioning as a switching element connected to a power supply -V. The amplifier circuit 20 basically corresponds with the amplifier circuit described in detail with reference to Figure 2. In Figure 1, the components which are the same as those shown in Figure 2 are marked with the same symbols, and their description is therefore omitted.

In the buffer amplifier circuit 20, a P channel type switching transistor 22 is provided on the input side of the driver circuit 0 for eliminating instability in the input to the driver circuit 0 when the transistor 5 is turned OFF. The drain/source circuit of the switching transistor 22 is connected between the input of the driver circuit 0 and the earth, while its gate is connected to the terminal 10.

As described previously, the control signal C is supplied to the terminal 10 by the DTMF signal generator 21 when the input terminal 8 is supplied with the DTMF signal S. The control signal C assumes earth level only during the output of the DTMF signal and assumes the level -V otherwise. Note that the input terminal 9 of the amplifier D is connected to the output terminal 11 of the circuit 20 so that feedback of the DTMF signal from the output terminal 11 is provided.

When the DTMF signal S is output from the DTMF signal generator 21, the control signal C assumes earth level, so that the transistor 5 is turned on. As a result, the operating electric current is fed from the power supply to the differential amplifier D. At the same time, the switching transistor 22 is turned OFF, and the input level of the driver circuit 0 is thereby allowed to vary in response to the output of the differential amplifier D. Thus, a desired output is provided at the output terminal 11 in response to the DTMF signal S.

When no DTMF signal S is output from the DTMF signal generator 21, the control signal C assumes the level -V. Consequently, the transistor 5 is turned OFF, thereby halting the supply of the operating current to the differential amplifier D. Waste consumption of electric current in the differential amplifier D is therefore restrained. Simultaneously, the switching transistor 22 is turned ON, and the input level of the driver circuit 0 is clamped substantially to earth level. Hence, even if the output of the differential amplifier D is in a floating state, the output of the driver circuit remains stable. At this time, the output of the terminal 11 is at the level -V.

Figure 3 shows a modification of the buffer amplifier circuit 20 depicted in Figure 1. The difference in the buffer amplifier circuit illustrated in Figure 3 is that the polarities of the respective transistors are the opposite of those of the transistors shown in Figure 1. The reference numerals indicating the transistors in Figure 3, which correspond to those of Figure 1, are marked with ( ). The function of the circuit depicted in Figure 3 is the same as that of the circuit of Figure 1.

In the foregoing embodiments, the present invention is applied to a circuit for buffer-amplifying a DTMF signal for a telephone system. The present invention is not, however, limited to such embodiments and may also be employed to amplify or buffer-amplify various other kinds of signals. The same effects can be obtained.

Thus, when the switching element 5 is in the ON state, the differential amplifier is supplied with the predetermined operating current from the power supply, while the clamping means do not function. The input level of the driver circuit varies in response to the output from the differential amplifer. A signal input to the differential amplifier is therefore output from the driver circuit.

On the other hand, when the switching element 5 is in the OFF state, no operating current is fed from the power supply to the differential amplifier, with the result that almost no electric power is consumed in the differential amplifier. In this case, the clamping means clamp the input level of the driver circuit to a predetermined level and hold the output of the driver circuit in a predetermined state, in spite of the fact that the output of the differential amplifier remains in a floating state.

In accordance with the present invention, it is thus possible to maintain the output level of the open drain type output circuit connected to the differential amplifier stable even when no operating current is supplied to the differential amplifier. As a result, the electric current for the differential amplifier can be switched ON and OFF, for the purpose of saving the electric power consumed, without creating problems.

## Claims

1. An amplifier circuit comprising a differential amplifying device (D) for receiving input signals from a signal generator, a driver circuit (0) responsive to an input received from the differential amplifying device for generating output signals, and switching means (5) for receiving control signals from the signal generator and for controlling the supply of operating current to the differential amplifying device in response to the control signals, and characterised by clamping means (22) arranged so as to clamp the input to the driver circuit to a predetermined level in association with the control by the switching means of the supply of operating current to the differential amplifying device.

2. A circuit according to claim 1, characterised in that the clamping means comprise further switching means.

3. A circuit according to claim 1 or 2, characterised in that the differential amplifying device has active loads (1,2) and in that the active loads, the clamping means and the driver circuit comprise P channel transistors, and the switching means comprise an N channel transistor.

4. A circuit according to claim 1 or 2, characterised in that the differential amplifying device has active loads (1′,2′), and in that the active loads, the clamping means and the driver circuit comprise N channel transistors, and the switching means comprise a P channel transistor.

5. An amplifier circuit comprising a signal generator (21), a differential amplifying device (D) having active loads (1,2; 1′,2′) receptive of electric signals from said signal generator, an open drain type driver circuit (0) receptive of an output from said differential amplifying device, and a switching device (5) for switching operating currents supplied to said differential amplifying device, said switching device being receptive of control signals from said signal generator and being provided between said differential amplifying device and a power supply, and characterised by a further switching device (22) receptive of said control signals, said further switching device switching according to said control signal levels to clamp said output level inputted to said open drain type driver circuit to a predetermined level.

# F I G. 1

# F I G. 2

# F I G. 3